# EUROPEAN PATENT SPECIFICATION

(11) **EP 3 223 306 B1**
(45) Date of publication and mention of the grant of the patent: **19.08.2020**
(21) Application number: 16162387.1
(22) Date of filing: 24.03.2016
(51) Int. Cl.: H01L 23/04, H01L 23/10, H01L 23/057

(54) **SEMICONDUCTOR PACKAGE**
HALBLEITERGEHÄUSE
BOÎTIER SEMI-CONDUCTEUR

(43) Date of publication of application: 27.09.2017
(73) Proprietor: Technische Hochschule Ingolstadt, 85049 Ingolstadt (DE)
(72) Inventor: ELGER, Gordon, 85053 Ingolstadt (DE)
(74) Representative: FDST Patentanwälte

(56) References cited:
- US-A- 5 219 794
- US-A- 5 926 371
- US-A1- 2006 060 891
- US-A1- 2008 224 153
- US-A1- 2014 306 327
- US-A1- 2016 039 665

## Description

The invention relates to a semiconductor package which comprises a semiconductor element and a cap with a cavity, wherein the semiconductor element is placed. The cap ensures hermetical encapsulating of the semiconductor element and, more particularly, serves as an interface to an external circuit board. The cap is made, for example, of silicon or ceramics and comprises conductive paths routed thereon for electrically contacting the inserted semiconductor element. The invention is useful for any particular semiconductor element, where a hermetic encapsulation would be helpful and where heat dissipation during use is needed. Particularly, the semiconductor element is a semiconductor die, i.e. is a small block of semiconducting material, on which a given functional circuit is fabricated. The semiconductor element is, for example, one of a diode, a diac, a triac, a thyristor, a transistor, an IGBT and a MOSFET. The semiconductor element is particularly used as a switch or rectifier in power electronics. In particular, the invention relates to a power semiconductor element. More particularly, the invention relates to packed semiconductor elements for switching or rectifying currents and/or voltages for drives in electro mobility. Generally, the invention relates to the technical field of microelectronics, particularly to packaging of semiconductor elements.

A similar device is disclosed, for example, in A. Hauffe, A. Kilian, M. Winter, L. Shiv, G. Elger et al.: "Optimized Micro-Via Technology for High Density and High Frequency (>40GHz) Hermetic Through-Wafer Connections in Silicon Substrates", Electronic Components and Technology Conference 2005, Proceedings 55th, p. 324-330 (doi:10.1109/ECTC.2005.1441286). The cavity of the shown semiconductor device is wet etched from one side of the cap and leaves a thin membrane in the bottom of the cavity. The membrane is opened from the back side at the locations of micro-vias in an additional etching step. After structuring conductive metal paths the openings in the membrane are hermetically sealed by metal plating. At the inside of the cavity conductive paths are formed which run from the micro-vias along the side walls of the cavity to the front side of the cap. For hermetically sealing the cap is placed with its cavity onto a semiconductor element which is bonded to a circuit board adapted in size and form, and the cap is soldered to the circuit board by a sealing ring which surrounds the cavity. The encapsulated semiconductor element is electrically connected from the back side of the cap over the vias and over the conductive paths along the inner side walls of the cavity which are electrically connected with metallization lines of the circuit board to which the semiconductor element is bonded. No direct electrical contact is given at the backside of the semiconductor element.

The micro-vias introduced into the bottom wall of the cavity allow a significant decrease in signal distortion at high frequencies when compared to conventional vias. Most of the depth for contacting the semiconductor element can be covered by impedance controlled conductive paths running down the side walls of the cavity.

Generally, the dominating electrical connection of semiconductor elements, e.g. "chips", is direct and wire bonding. Wire bonding causes additional inductance by the bond loops which cause parasitic effects like high voltage peaks when switching the element. High voltage peaks can cause failures during operation and a faster degradation thereby reducing the reliability of the device. Accordingly, a replacement of the wire bonds will increase the reliability. For a direct bonding solder or other bonding materials are deposited on the contact pads of the semiconductor element. For mounting the semiconductor element to a circuit board or substrate, it is flipped over so that its top side faces down and the solder bumps at the pads are aligned with matching pads on the circuit board. In a subsequent reflow process the pads of the semiconductor element and the pads of the circuit board then become soldered.

Humidity and corrosive atmosphere both cause degradation and failures of the semiconductor elements. This problem is solved, as already mentioned above, in a known manner by packages which encapsulate or hermetically seal a semiconductor element placed therein. Use of such packages will increase the lifetime of the semiconductor elements but will also cause additional costs. Usually, the encapsulated semiconductor element is electrically contacted with the aid of electrical vias through the package which are filled with metal. The fabrication of the vias has to be implemented as an additional production step and increases the costs on the whole.

A semiconductor package according to the first part of claim 1 is disclosed in US 2014/0306327 A1. Similar semiconductor packages are known from US 2006/0060891 A1 and US 2008/0224153 A1.

US 2016/0039665 A1 discloses a sealed packing having a device disposed on a wafer structure and slid structure boned to the device wafer.

It is an object of the present invention to provide an aforementioned semiconductor package with an improved reliability which can be fabricated at low cost and which can be easily mounted onto an external circuit board or substrate. According to the invention, this object is solved by providing a semiconductor package in accordance with claim 1.

The semiconductor element is attached to the cap by bonding its first electric contact surface to the first electric contact surface at the inner side of the bottom wall of the cavity. Generally, any standard bonding process like glueing with an electrically conductive adhesive, soldering or sintering can be used for attaching the semiconductor element to the cap. Preferably, a flip chip process is used. Particularly, a high melting solder alloy is used to avoid remelting of the interface during the reflow process. Also diffusion soldering or transit liquid phase soldering can be used to interconnect the semiconductor element to the cap. The process of attaching the semiconductor element to the cap is preferably performed on a wafer level.

Together with an external circuit board or substrate the cap enables hermetic packaging of the semiconductor element. The first conductive path routed at the cap is thereby used to electrically contact the first contact surface located at the first side of the semiconductor element at the bottom wall of the cavity. To avoid a signal reflection at the semiconductor and to increase the transfer of electrical the conductive path is impedance matched by its electrical routing on the cap. The direct electrically conductive connection of the first electrical contact surface at the first side of the semiconductor element provides low parasitic impedance. The direct interconnection also increases the transfer of heat from the semiconductor element to the cap. This additionally increases the reliability of the device.

The conductive paths which are routed along the cap can be fabricated by a lithographic process combined with metal deposition, like electroless plating or electroplating, a CVD or a PVD-process. Other processes like direct laser ablation, plasma deposition, dispensing, jetting or printing of conductive material might be also used.

According to a preferred embodiment of the invention, the total height of the cavity matches the total height of the semiconductor element so that the second side of the semiconductor element is aligned with the first side of the cap outside of the cavity. In other words, in the assembled package the second side of the semiconductor element is leveled with the edge of the cap surrounding the cavity. Accordingly, a robust cap assembly is provided which is easily mountable onto the surface of an external circuit board or substrate. The cap-semiconductor assembly as such represents a surface mountable device (SMD).

Advantageously, the semiconductor package further comprises at the first side of the cap a closed ring-like structure surrounding the cavity, wherein the ring-like structure comprises a layer of a material that is adapted for connecting the cap to a substrate in a material-locking manner. The ring-like structure or sealing ring enables hermetic packaging of the semiconductor element. The semiconductor-cap assembly is placed on the substrate. Subsequently, the sealing ring is used for connecting the cap to the substrate whereby the semiconductor element becomes hermetically encapsulated within the cavity. The cavity of the cap is closed by the substrate. Preferably, the ring-like structure comprises a layer of a solderable material, particularly, a metal or an alloy. After placing the cap onto the substrate the cap and the substrate are soldered, for example, by a reflow process.

According to another preferred embodiment, a glass layer is printed on the substrate which subsequently is metalized. The sealing ring then is soldered to the metallization located on the glass layer. By using a glass layer the ring-like structure of the cap is electrically isolated from the substrate. Additionally, the glass layer bridges gaps on the surface of the substrate which in turn provides for an optimal hermetic sealing. Generally, between the solderable material and the metal layers additional layers of glass or alloys can be added for improving a connection in a material-locking manner and/or to stop solder from flowing during fabrication. Typically, a flux free (i.e. residual free) soldering process under nitrogen atmosphere or under vacuum conditions is used. In case of vacuum soldering, getter material can be added. Typically, a Ni containing solder is used. A Ni/Au layer may be used for interconnecting the Ni solder and a Cu metallization. A glass layer or a ceramic layer may be used as a solder stop.

According to the invention as claimed, the semiconductor element further comprises a third electric surface on the first side which is electrically isolated from the first electric contact surface on the first side, wherein the cap further comprises a second conductive path forming a second electric contact surface located at the inner side of the bottom wall of the cavity which is electrically isolated from the first electric contact surface located at the inner side of the bottom wall of the cavity, and wherein the third electric contact surface at the first side of the semiconductor element and the second electric contact surface at the inner side of the bottom wall of the cavity are electrically conductive bonded in a material-locking manner. In other words, a semiconductor element is used which has two electric contact surfaces at the first side, namely the first and the third electric contact surfaces, and which has one electric contact surface at the second side, namely the second electric contact surface. The first and the third electric contact surfaces are electrically conductive bonded to the first and the second conductive path respectively which are routed along the cap. Preferably, a source contact surface and a gate contact surface of the semiconductor element are connected to the cap and a drain contact surface of the semiconductor element is bonded to the substrate during the mounting process. A thermally and electrically conductive connection of the drain contact surface and the substrate will increase the transfer of heat from the semiconductor element to the substrate and will increase in turn the reliability of the device. An excellent heat management is possible due to the fact that the cap-substrate assembly allows an efficient cooling of the encapsulated semiconductor element from both the bottom and the top. Preferably, a heat sink is comprised which is placed on top of the cap, i.e. the second side of the cap. A heat sink can also be placed on the bottom side of the substrate. Advantageously, the cap and the substrate both comprise a heat sink.

According to the invention, the first conductive path extends between the first electric contact surface located at the inner side of the bottom wall of the cavity and a third electric contact surface located at the first side of the cap outside of the cavity and the second conductive path extends between the second electric contact surface located at the inner side of the bottom wall of the cavity and a fourth electric contact surface located at the first side of the cap outside of the cavity. The third and the fourth electric contact surface located at the edge of the cap surrounding the cavity enable an electrically conductive bonding to a metallization layer on the substrate whereby the first and the third electric contact surfaces on the first side of the semiconductor element become electrically integrated into a circuitry of the substrate.

The first and the second conductive paths as such are routed along the inner side of the side walls of the cavity of the cap. Preferably, the material of the cap comprises silicon or ceramic. Advantageously, the semiconductor element is a power semiconductor element, particularly a high power semiconductor element. A preferred semiconductor element is one of a diode, a diac, a triac, a thyristor, a transistor, an IGBT and a MOSFET.

According to yet another preferred embodiment of the invention, the cap is placed onto a substrate, wherein the ring-like structure is bonded to the substrate in a material-locking manner, and wherein the semiconductor element is hermetically encapsulated within the cavity of a cap. The sealing can be reached, for example, by a reflow process whereby a solderable material is molded.

Advantageously, the substrate further comprises disjunct metallization areas, wherein the second electric contact surface at the second side of the semiconductor element and at least one of the metallization areas are electrically conductive bonded in a material-locking manner. This direct bonding allows increasing the heat transfer from the semiconductor element to the substrate as already described above.

Preferably, at least one of the third electric contact surface and the fourth electric contact surface at the first side of the cap is electrically conductive bonded to at least one of the metallization areas in a material-locking manner. Preferably, a soldering process like reflow soldering is used. However, any other process for electrically conductive bonding can be used.

According to yet another preferred embodiment of the invention, the ring-like structure and at least one of the metallization areas are bonded in a material-locking manner. Preferably, as already mentioned, a bonding structure which connects the ring-like structure and at least one of the metallization areas comprises an electrically isolating layer. The electrically isolating layer is preferably a glass layer.

Advantageously, the substrate is a direct bonded copper substrate (DBC substrate). A DBC substrate is composed of a ceramic tile, typically alumina, with a sheet of copper or a metallization area of copper bonded on one side or on both sides of the substrate.

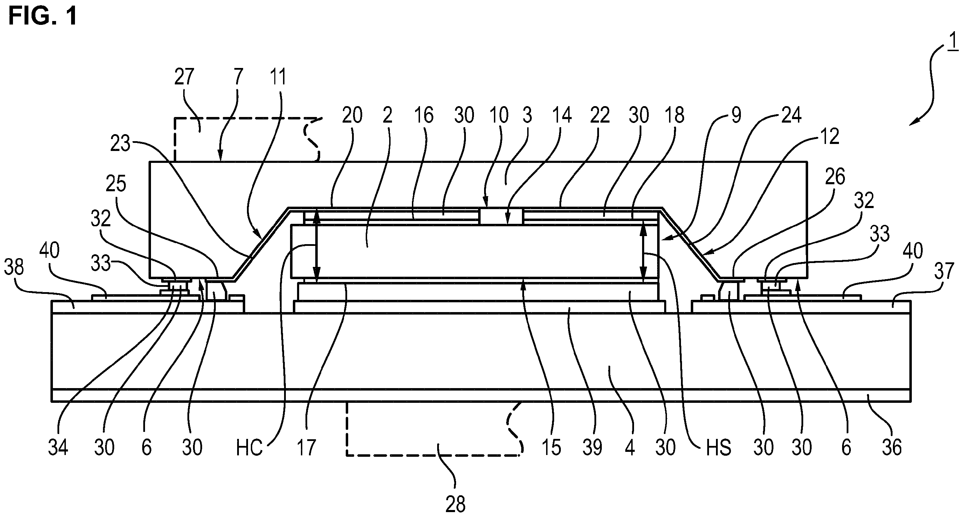

The advantages and purposes of the invention become more apparent from a study of the following figure 1 which shows an embodiment of the invention, i.e. a semiconductor package comprising a cap and a substrate, wherein conductive paths are routed along the inner side of a cavity in the cap.

Figure 1 shows in a first embodiment of the invention a semiconductor package 1 which comprises a semiconductor element 2 (e.g. a power semiconductor element) that is placed in a cap 3 which is mounted on a substrate 4. The semiconductor element 2 is hermetically encapsulated within the cap 3 which is closed by the substrate 4.

The cap 3 comprises a first side 6 (i.e. the upper side) and a second side 7 (i.e. the lower side). At the first side 6 of the cap 3 a cavity 9 is introduced. The cavity 9 is fabricated, for example, by a wet etching process. The cap 3 is made, for example, of silicon or of ceramics.

The cavity 9 comprises a bottom wall 10 and side walls 11, 12. The semiconductor element 2 is mounted with its first side 14 (i.e. the upper side) at the bottom wall 10 of the cavity 9. The second side (i.e. the lower side) 15 of the semiconductor element 2 is mounted on the substrate 4. The substrate 4 comprises, for example, an electric circuitry and also other electronic elements may be mounted on the substrate 4.

The semiconductor element 2 comprises at its first side 14 a first contact surface 16 and a third contact surface 18, which are for example a source contact surface and a gate contact surface, respectively. A second contact surface 17 is located at the second side 15 of the semiconductor element 2. The second contact surface 17 is, for example, a drain contact surface of the semiconductor element 2.

Before placed and mounted on the surface of the substrate 4, the semiconductor element 2 is attached to the cap 3 to form a mounted cap-semiconductor assembly. For attaching the semiconductor element 2 to the cap 3 the first contact surface 16 of the semiconductor element 2 and the third contact surface 18 of the semiconductor element 2 are electrically and mechanically connected to a first contact surface 20 and a second contact surface 22, respectively, located at the inner side of the bottom wall 10 of the cavity 9 of the cap 3. The contact surfaces 16, 18 of the semiconductor element 2 are, for example, metal pads. The contact surfaces 20, 22 within the cavity 9 of the cap 3 are, for example, metallization layers (e.g. made of Cu) which are deposited on the surface of the cap 3. The semiconductor element 2 is mounted at the inner side of the bottom wall 10, for example, by the flip chip process where solder bumps 30 are placed at the metal pads of the semiconductor element 2 which then is flipped and placed at the bottom wall 10 within the cavity 9 of the cap 3. By reflow soldering the respective contact surfaces 16, 18, 20, 22 then become soldered. Generally, also other known standard mounting process technologies can be used to attach the semiconductor element 2 to the bottom wall 10 of the cap 3.

In the mounted assembly of the semiconductor element 2 and the cap 3 the total height HC of the cavity 9 and the total height HS of the semiconductor element 2 are matched so that the second side 15 of the semiconductor element 2 and the edge of the cap 3 at its first side 6 are aligned. This enables an easy mounting process of the cap-semiconductor assembly. Also a robust and easily handable assembly is provided.

To electrically contact the contact surfaces 16, 17 on the first, upper side 14 of the semiconductor element 2 a first conductive path 23 and a second conductive path 24 are routed along the side walls 11, 12, respectively, within the cavity 9 and form a third contact surface 25 and a fourth contact surface 26, respectively, on the first side 6 of the cap 3. These contact surfaces 25, 26 can be easily bonded to the substrate 4. The direct bonding of the contact pads of the semiconductor element 2 with the contact surfaces 20, 22 within the cavity 9 of the cap 3 provides an excellent thermal conductance. A heat sink 27 is placed on the second, upper side 7 of the cap 3 for cooling the semiconductor element 2. An additional heat sink 28 is placed at the bottom side of the substrate 4.

The cap 3 further comprises a ring-like sealing structure 33 at its first side 6 for hermetically encapsulating the semiconductor element 2 when the cap-semiconductor assembly is mounted on the surface of the substrate 4. The ring-like structure 33 comprises, for example, a layer 32 of a solderable material which is attached to the cap 3. The layer 32 comprises, for example, a metal or an alloy, particularly Cu. For soldering a solder 30 is attached to the layer 32 and the cap 3 is mounted on the surface of the substrate 4 by a reflow process. At the same time also the second contact surface 17 of the semiconductor element 2, the third contact surface 25 and the fourth contact surface 26 of the cap 3 become soldered and are electrically conductive bonded with disjunct metallization areas 39, 38 and 37, respectively, on the surface of the substrate 4. Other bonding processes are also possible.

On the metallization areas 37 and 38 of the substrate 4 further isolating layers 40 which are made, for example, of glass are deposited. The isolation layers 40 act as a solder stop. Additionally, the ring-like sealing structure 33 is electrically isolated from the metallization areas 37 and 38. The metallization areas 37 and 38 become not shortened by the sealing structure 33. The bonding structures 34 may comprise additional layers for establishing an optimum mechanical and electrical connection in a material-locking manner. The conductive paths 23, 24 which are routed along the side walls 11, 12, respectively, of the cavity 9 of the cap 3 are particularly impedance matched. The substrate 4 is, for example, given as a DCB substrate.

### Reference numerals

- 1: Semiconductor package
- 2: Semiconductor element
- 3: Cap
- 4: Substrate
- 6: First side of the cap
- 7: Second side of the cap
- 9: Cavity
- 10: Bottom wall
- 11: Side wall
- 12: Side wall
- 14: First side of the semiconductor element
- 15: Second side of the semiconductor element
- 16: First contact surface of the semiconductor element
- 17: Second contact surface of the semiconductor element
- 18: Third contact surface of the semiconductor element
- 20: First contact surface of the cap
- 22: Second contact surface of the cap
- 23: First conductive path
- 24: Second conductive path
- 25: Third contact surface of cap
- 26: Fourth contact surface of cap
- 27: Heat sink
- 28: Heat sink
- 30: Solder
- 32: Layer
- 33: Ring like structure (Sealing ring)
- 34: Bonding structure
- 36: Metallization area
- 37: Metallization area
- 38: Metallization area
- 39: Metallization area
- 40: Isolating layer

- HS: Total height of the semiconductor element
- HC: Total height of the cavity

## Claims

1. A semiconductor package (1), the package (1) comprising:
- a semiconductor element (2) comprising a first electric contact surface (16) and a third electric contact surface (18) on a first side (14) and a second electric contact surface (17) on a second side (15) opposite to the first side (14), which first and third electric contact surfaces (18) of the semiconductor element (2) are electrically isolated from each other, and
- a cap (3) comprising a first side (6) and a second side (7) opposite to the first side (6), a cavity (9) which is located at the first side (6) of the cap (3) and has a bottom wall (10) and side walls (11, 12) and which is dimensioned to receive the semiconductor element (2), the cap (3) further comprising a first conductive path (23) comprising a first electric contact surface (20) and a second conductive path (24) comprising a second electric contact surface (22), which first and second electric contact surfaces (20,22) of the cap (3) are isolated from each other,
wherein the semiconductor element (2) is fixed within the cavity (9), wherein the first electric contact surface (16) of the semiconductor element (2) and the first electric contact surface (20) of the cap (3) are electrically conductive bonded in a material-locking manner, and wherein the third electric contact surface (18) of the semiconductor element (2) and the second electric contact surface (22) of the cap (3) are electrically conductive bonded in a material-locking manner,
wherein the first and second electric contact surfaces (20,22) of the cap (3) are located at the inner side of the bottom wall (10) of the cavity (9),
**characterized in that**
the first conductive path (23) extends between the first electric contact surface (20) located at the inner side of the bottom wall (10) of the cavity (9) and a third electric contact surface (25) located at the first side (6) of the cap (3) outside of the cavity (9) and the second conductive path (24) extends between the second electric contact surface (24) located at the inner side of the bottom wall (10) of the cavity (9) and a fourth electric contact surface (26) located at the first side (6) of the cap (3) outside of the cavity (9) and the first and the second conductive paths are routed along the inner side of the side walls of the cavity of the cap.

2. The semiconductor package (1) of claim 1, wherein the total height (HC) of the cavity (9) matches the total height (HS) of the semiconductor element (2) so that the second side (15) of the semiconductor element (2) is aligned with the first side (6) of the cap (3) outside of the cavity (9).

3. The semiconductor package (1) of claim 1 or 2, further comprising at the first side (6) of the cap a closed ring-like structure (33) surrounding the cavity (9), the ring-like structure (33) comprising a layer (32) of a material that is adapted for connecting the cap (3) to a substrate (4) in a material-locking manner.

4. The semiconductor package (1) of claim 3, wherein the ring-like structure (33) comprises a layer (32) of a solderable material (30), particularly a metal or an alloy.

5. The semiconductor package (1) of any of the preceding claims, wherein the material of the cap (3) comprises silicon or ceramics.

6. The semiconductor package (1) of any of the preceding claims, wherein the semiconductor element (2) is one of a Diode, a Diac, a Triac, a Thyristor, a transistor, an IGBT and a MOSFET.

7. The semiconductor package (1) of any of claims 2 to 6, wherein the cap (3) is placed onto a substrate (4), wherein the ring-like structure (33) is bonded to the substrate (4) in a material-locking manner, and wherein the semiconductor element (2) is hermetically encapsulated within the cavity (9) of the cap (3).

8. The semiconductor package (1) of claim 7, wherein the substrate (4) further comprises disjunct metallization areas (36, 37, 38) and wherein the second electric contact surface (17) at the second side (15) of the semiconductor element (2) and at least one of the metallization areas (36, 37, 38) are electrically conductive bonded in a material-locking manner.

9. The semiconductor package (1) of claim 8, wherein at least one of the third electric contact surface (25) and the fourth electric contact surface (26) at the first side (6) of the cap (3) is electrically conductive bonded to at least one of the metallization areas (36, 37, 38) in a material-locking manner.

10. The semiconductor package (1) of claim 8 or 9, wherein the ring-like structure (33) and at least one of the metallization areas (36, 37, 38) are bonded in a material-locking manner.

11. The semiconductor package (1) of claim 10, wherein a bonding structure (34) which connects the ring-like structure (33) and at least one of the metallization areas (36, 37, 38) comprises an electrically isolating layer (40).

## Patentansprüche

1. Halbleiterpaket (1), wobei das Paket (1) umfasst:
- ein Halbleiterelement (2) mit einer ersten elektrischen Kontaktfläche (16) und einer dritten elektrischen Kontaktfläche (18) auf einer ersten Seite (14) sowie einer zweiten elektrischen Kontaktfläche (17) auf einer zweiten Seite (15), die der ersten Seite (14) gegenüberliegt, wobei die erste und die dritte elektrische Kontaktfläche (18) des Halbleiterelements (2) elektrisch voneinander isoliert sind, und
- eine Kappe (3) mit einer ersten Seite (6) und einer der ersten Seite (6) gegenüberliegenden zweiten Seite (7), einem Hohlraum (9), der sich an der ersten Seite (6) der Kappe (3) befindet und eine Bodenwand (10) sowie Seitenwände (11, 12) aufweist, und der so dimensioniert ist, dass er das Halbleiterelement (2) aufnimmt, wobei die Kappe (3) ferner einen ersten leitenden Pfad (23) mit einer ersten elektrischen Kontaktfläche (20) und einen zweiten leitenden Pfad (24) mit einer zweiten elektrischen Kontaktfläche (22) aufweist, wobei die erste und die zweite elektrische Kontaktfläche (20, 22) der Kappe (3) voneinander isoliert sind,
wobei das Halbleiterelement (2) innerhalb des Hohlraums (9) fixiert ist, wobei die erste elektrische Kontaktfläche (16) des Halbleiterelements (2) und die erste elektrische Kontaktfläche (20) der Kappe (3) elektrisch leitend und materialschlüssig verbunden sind, und wobei die dritte elektrische Kontaktfläche (18) des Halbleiterelements (2) und die zweite elektrische Kontaktfläche (22) der Kappe (3) elektrisch leitend und materialschlüssig verbunden sind,
wobei die ersten und zweiten elektrischen Kontaktflächen (20, 22) der Kappe (3) an der Innenseite der Bodenwand (10) des Hohlraums (9) angeordnet sind,
**dadurch gekennzeichnet, dass**
die erste Leiterbahn (23) zwischen der ersten an der Innenseite der Bodenwand (10) des Hohlraums (9) angeordneten ersten elektrischen Kontaktfläche (20) und einer an der ersten Seite (6) der Kappe (3) außerhalb des Hohlraums (9) angeordneten dritten elektrischen Kontaktfläche (25) verläuft und die zweite Leiterbahn (24) zwischen der zweiten an der Innenseite der Bodenwand (10) des Hohlraums (9) angeordneten elektrischen Kontaktfläche (24) und einer vierten an der ersten Seite (6) der Kappe (3) außerhalb des Hohlraums (9) angeordneten elektrischen Kontaktfläche (26) verläuft, und die erste und die zweite Leiterbahn entlang der Innenseite der Seitenwände des Hohlraums der Kappe geführt werden.

2. Halbleiterpaket (1) nach Anspruch 1, wobei die Gesamthöhe (HC) des Hohlraums (9) mit der Gesamthöhe (HS) des Halbleiterelements übereinstimmt (2), so dass die zweite Seite (15) des Halbleiterelements (2) mit der ersten Seite (6) der Kappe (3) außerhalb des Hohlraums (9) ausgerichtet ist.

3. Halbleiterpaket (1) nach Anspruch 1 oder 2, das an der ersten Seite (6) der Kappe ferner eine geschlossene ringförmige Struktur (33) umfasst, welche den Hohlraum umgibt, wobei die ringförmige Struktur (33) eine Schicht (32) aus einem Material aufweist, das zur materialschlüssigen Verbindung der Kappe (3) mit einem Substrat (4) geeignet ist.

4. Halbleiterpaket (1) nach Anspruch 3, wobei die ringförmige Struktur (33) eine Schicht (32) aus einem lötbaren Material (30), insbesondere einem Metall oder einer Legierung, umfasst.

5. Halbleiterpaket (1) nach einem der vorhergehenden Ansprüche, wobei das Material der Kappe (3) Silizium oder Keramik umfasst.

6. Halbleiterpaket (1) nach einem der vorhergehenden Ansprüche, wobei das Halbleiterelement (2) eine Diode, ein Diac, ein Triac, ein Thyristor, ein Transistor, ein IGBT und ein MOSFET ist.

7. Halbleiterpaket (1) nach einem der Ansprüche 2 bis 6, bei dem die Kappe (3) auf einem Substrat (4) aufgesetzt ist, wobei die ringförmige Struktur (33) materialschlüssig mit dem Substrat (4) verbunden ist, und wobei das Halbleiterelement (2) hermetisch in dem Hohlraum (9) der Kappe (3) eingekapselt ist.

8. Halbleiterpaket (1) nach Anspruch 7, wobei das Substrat (4) ferner disjunkte Metallisierungsbereiche (36, 37, 38) aufweist und wobei die zweite elektrische Kontaktfläche (17) auf der zweiten Seite (15) des Halbleiterelements (2) und mindestens einer der Metallisierungsbereiche (36, 37, 38) elektrisch leitend und materialschlüssig miteinander verbunden sind.

9. Halbleiterpaket (1) nach Anspruch 8, wobei mindestens eine der dritten elektrischen Kontaktfläche (25) und der vierten elektrischen Kontaktfläche (26) auf der ersten Seite (6) der Kappe (3) elektrisch leitend und materialschlüssig mit einem der Metallisierungsbereiche (36, 37, 38) verbunden ist.

10. Halbleiterpaket (1) nach Anspruch 8 oder 9, wobei die ringförmige Struktur (33) und mindestens einer der Metallisierungsbereiche (36, 37, 38) materialschlüssig miteinander verbunden sind.

11. Halbleiterpaket (1) nach Anspruch 10, wobei eine Verbindungsstruktur (34), die die ringförmige Struktur (33) und mindestens einen der Metallisierungsbereiche (36, 37, 38) verbindet, eine elektrisch isolierende Schicht (40) umfasst.

## Revendications

1. Module semi-conducteur (1), le module (1) comprenant :
- un élément semi-conducteur (2) comprenant une première surface de contact électrique (16) et une troisième surface de contact électrique (18) sur un premier côté (14) et une deuxième surface de contact électrique (17) sur un deuxième côté (15) opposé au premier côté (14), dans lequel la première et la troisième surface de contact électrique (18) de l'élément semi-conducteur (2) sont électriquement isolées l'une de l'autre, et
- un capuchon (3) comprenant un premier côté (6) et un second côté (7) opposé au premier côté (6), une cavité (9) qui est située sur le premier côté (6) du capuchon (3) et qui a une paroi de fond (10) et des parois latérales (11, 12) et qui est dimensionné pour recevoir l'élément semi-conducteur (2), le capuchon (3) comprenant en outre un premier chemin conducteur (23) comprenant une première surface de contact électrique (20) et un deuxième chemin conducteur (24) comprenant une deuxième surface de contact électrique (22), dans lequel la première et la deuxième surface de contact électrique (20, 22) du capuchon (3) sont isolées l'une de l'autre,
dans lequel l'élément semi-conducteur (2) est fixé dans la cavité (9), dans lequel la première surface de contact électrique (16) de l'élément semi-conducteur (2) et la première surface de contact électrique (20) du capuchon (3) sont reliées de manière électriquement conductrice par conjugaison de matière, et dans lequel la troisième surface de contact électrique (18) de l'élément semi-conducteur (2) et la deuxième surface de contact électrique (22) du capuchon (3) sont reliées de manière électriquement conductrice par conjugaison de matière, dans lequel les première et deuxième surfaces de contact électrique (20, 22) du capuchon (3) sont situées sur le côté intérieur de la paroi inférieure (10) de la cavité (9),
**caractérisé en ce que**
le premier chemin conducteur (23) s'étend entre la première surface de contact électrique (20) située sur le côté intérieur de la paroi inférieure (10) de la cavité (9) et une troisième surface de contact électrique (25) située sur le premier côté (6) du capuchon (3) à l'extérieur de la cavité (9) et le deuxième chemin conducteur (24) s'étend entre la deuxième surface de contact électrique (24) située sur le côté intérieur de la paroi inférieure (10) de la cavité (9) et une quatrième surface de contact électrique (26) située sur le premier côté (6) du capuchon (3) à l'extérieur de la cavité (9), et le premier et le deuxième chemin conducteur sont acheminés le long de la face interne des parois latérales de la cavité du bouchon.

2. Module semi-conducteur (1) selon la revendication 1, dans lequel la hauteur totale (HC) de la cavité (9) correspond à la hauteur totale (HS) de l'élément semi-conducteur (2) de sorte que le deuxième côté (15) de l'élément semi-conducteur (2) soit aligné avec le premier côté (6) du capuchon (3) à l'extérieur de la cavité (9).

3. Module semi-conducteur (1) selon la revendication 1 ou 2, comprenant en outre sur le premier côté (6) du capuchon une structure annulaire fermée (33) entourant la cavité (9), ladite structure annulaire (33) comprenant une couche (32) d'un matériau qui est adaptée pour relier le capuchon (3) à un substrat (4) par une liaison par la matière.

4. Module semi-conducteur (1) selon la revendication 3, dans lequel la structure annulaire (33) comprend une couche (32) d'un matériau soudable (30), notamment un métal ou un alliage.

5. Module semi-conducteur (1) selon l'une des revendications précédentes, dans lequel le matériau du capuchon (3) comprend du silicium ou de la céramique.

6. Module semi-conducteur (1) selon l'une des revendications précédentes, dans lequel l'élément semi-conducteur (2) est l'un des éléments suivants : une diode, un diac, un triac, un thyristor, un transistor, un IGBT et un MOSFET.

7. Module semi-conducteur (1) selon l'une des revendications 2 à 6, dans lequel le capuchon (3) est placé sur un substrat (4), dans lequel la structure annulaire (33) est reliée au substrat (4) par conjugaison de matière, et dans lequel l'élément semi-conducteur (2) est encapsulé hermétiquement dans la cavité (9) du capuchon (3).

8. Module semi-conducteur (1) selon la revendication 7, dans lequel le substrat (4) comprend en outre des zones de métallisation disjointes (36, 37, 38) et dans lequel la deuxième surface de contact électrique (17) sur le deuxième côté (15) de l'élément semi-conducteur (2) et au moins l'une des zones de métallisation (36, 37, 38) sont reliés de manière électriquement conductrice par conjugaison de matière.

9. Module semi-conducteur (1) selon la revendication 8, dans lequel au moins l'une des troisième (25) et quatrième (26) surfaces de contact électrique sur le premier côté (6) du capuchon (3) est reliée de manière électriquement conductrice à au moins l'une des zones de métallisation (36, 37, 38) par conjugaison de matière.

10. Module semi-conducteur (1) selon la revendication 8 ou 9, dans lequel la structure annulaire (33) et au moins l'une des zones de métallisation (36, 37, 38) sont reliés par conjugaison de matière.

11. Module semi-conducteur (1) selon la revendication 10, dans lequel une structure de liaison (34), qui relie la structure annulaire (33) et au moins l'une des zones de métallisation (36, 37, 38), comprend une couche électriquement isolante (40).
